# EUROPEAN PATENT APPLICATION

(11) **EP 3 905 096 A1**
(43) Date of publication of application: **03.11.2021**
(21) Application number: 20172375.6
(22) Date of filing: 30.04.2020
(51) Int. Cl.: G06F 30/23, G06F 30/15

(54) **METHOD AND APPARATUS FOR COMPARING A SIMULATION OF A PHYSICAL OBJECT WITH MEASUREMENT DATA OF THE PHYSICAL OBJECT, AND METHOD AND AN APPARATUS FOR GENERATING A FINITE ELE-MENT REPRESENTATION OF MEASUREMENT DATA OF A PHYSICAL OBJECT**

(71) Applicant: Fraunhofer-Gesellschaft zur Förderung der angewandten Forschung e.V., 80686 München (DE)
(72) Inventor: Soot, Thomas, 79104 Freiburg (DE); Dr. Dlugosch, Michael, 79104 Freiburg (DE); Dr. Fritsch, Jens, 79104 Freiburg (DE)
(74) Representative: 2SPL Patentanwälte PartG mbB

(57) **Abstract**

A computer-implemented method for comparing a simulation of a physical object with measurement data obtained in an experiment is provided. A finite element representation of a virtual object for interacting and restraining an evolution of the finite element representation of the physical object in the simulation is provided for a time step tₖ of the simulation. The method comprises determining, based on the measurement data of the physical object for the time step tₖ₊ᵢ, (k+i)-th modification data for the virtual object in the time step tₖ₊ᵢ₋₁. The physical object for the time step tₖ₊ᵢ is determined based on the finite element representation of the physical object for tₖ₊ᵢ₋₁, the finite element representation of the virtual object for tₖ₊ᵢ₋₁ and the (k+i)-th modification data. Information is output on interaction of the virtual object with the finite element representation of the physical object.

## Description

### Field

The present disclosure relates to simulations. In particular, examples relate to a computer-implemented method and an apparatus for comparing a simulation of a physical object with measurement data of the physical object obtained in an experiment. Further examples relate to a computer-implemented method and an apparatus for generating a finite element representation of measurement data of a physical object obtained in an experiment.

### Background

Simulations are used in various technological fields for product development. For example, simulations are used to virtualize vehicle development. Reliable virtual vehicle development requires validated simulation methods and simulation models with high predictive power. With ongoing digitalization, the ability to integrate experimental and virtual data sets becomes more and more important.

Typically, multiple detection systems and very often leading edge of technology detection systems are used for collecting data in experiments during vehicle development (e.g. in crash experiments). The thus obtained measurement data may be diverse in terms of spatial and temporal resolution. Processing the measurement data such that it may be used for validating simulation methods and/or simulation models is a major task for enabling fully virtualized vehicle development. The generation of physically based and interpretable data sets that describe discrepancies between the measurement data and the simulation results is a key factor for identifying potential roots of the discrepancies.

Hence, there may be a demand for an improved comparison of a simulation of a physical object with experimental measurement data of the physical object. Further, there may be a demand for improved processing of measurement data of a physical object.

### Summary

This demand is met by computer-implemented methods and apparatuses in accordance with the independent claims. Advantageous embodiments are addressed by the dependent claims.

According to a first aspect, the present disclosure provides a computer-implemented method for comparing a simulation of a physical object with measurement data of the physical object obtained in an experiment. A finite element representation of a virtual object for interacting with a finite element representation of the physical object in order to restrain an evolution of the finite element representation of the physical object in the simulation is provided for a time step tk of the simulation. The method comprises for one or more subsequent time steps tₖ₊ᵢ of the simulation determining, based on the measurement data of the physical object for the time step tₖ₊ᵢ, (k+i)-th modification data for nodes of the finite element representation of the virtual object in the time step tₖ₊ᵢ₋₁. The (k+i)-th modification data indicates modifications to data assigned to the nodes of the finite element representation of the virtual object from the time step tₖ₊ᵢ₋₁ to the time step tₖ₊ᵢ. Further, the method comprises for the one or more subsequent time steps tₖ₊ᵢ of the simulation determining the finite element representation of the physical object for the time step tₖ₊ᵢ based on the finite element representation of the physical object for the time step tₖ₊ᵢ₋₁, the finite element representation of the virtual object for the time step tk+i-i and the (k+i)-th modification data. The method additionally comprises outputting information about the interaction of the finite element representation of the virtual object with the finite element representation of the physical object.

According to a second aspect, the present disclosure provides an apparatus for comparing a simulation of a physical object with measurement data of the physical object from an experiment. A finite element representation of a virtual object for interacting with a finite element representation of the physical object in the simulation in order to restrain an evolution of the finite element representation of the physical object is provided for a time step tk of the simulation. The apparatus comprises an input interface configured to receive the measurement data of the physical object. Further, the apparatus comprises a processing circuit configured to perform the following for one or more subsequent time steps tₖ₊ᵢ of the simulation: determining, based on the measurement data of the physical object for the time step tₖ₊ᵢ, (k+i)-th modification data for nodes of the finite element representation of the virtual object in the time step tₖ₊ᵢ₋₁, wherein the (k+i)-th modification data indicates modifications to data assigned to the nodes of the finite element representation of the virtual object from the time step tk+i-i to the time step tₖ₊ᵢ; determining the finite element representation of the physical object for the time step tₖ₊ᵢ based on the finite element representation of the physical object for the time step tₖ₊ᵢ₋₁, the finite element representation of the virtual object for the time step tₖ₊ᵢ₋₁ and the (k+i)-th modification data; and outputting information about the interaction of the finite element representation of the virtual object with the finite element representation of the physical object.

Examples according to the first and the second aspect of the present disclosure may enable improved comparison of the simulation and the measurement data of the experiment.

According to a third aspect, the present disclosure provides a computer-implemented method for generating a finite element representation of measurement data of a physical object obtained in an experiment. The method comprises allocating the measurement data of the physical object to nodes of a finite element representation of the physical object. Further, the method comprises determining deviations between the measurement data of the physical object and data assigned to the allocated nodes of the finite element representation of the physical object. The method comprises determining distances between the nodes of the finite element representation of the physical object. Additionally, the method comprises determining virtual measurement data for the physical object by interpolating the deviations based on the finite element representation of the physical object and the distances between the nodes of the finite element representation of the physical object. Further, the method comprises determining the finite element representation of the measurement data based on the measurement data for the physical object and the virtual measurement data for the physical object.

According to a fourth aspect, the present disclosure provides an apparatus for generating a finite element representation of measurement data of a physical object obtained in an experiment. The apparatus comprises an input interface configured to receive the measurement data of the physical object. Further, the apparatus comprises a processing circuit configured to allocate the measurement data of the physical object to nodes of a finite element representation of the physical object. The processing circuit is configured to determine deviations between the measurement data of the physical object and data assigned to the allocated nodes of the finite element representation of the physical object. Additionally, the processing circuit is configured to determine distances between the nodes of the finite element representation of the physical object. The processing circuit is configured to determine virtual measurement data for the physical object by interpolating the deviations based on the finite element representation of the physical object and the distances between the nodes of the finite element representation of the physical object. Further, the processing circuit is configured to determine the finite element representation of the measurement data based on the measurement data for the physical object and the virtual measurement data for the physical object.

Examples according to the third and the fourth aspect of the present disclosure may enable improved processing of measurement data of a physical object.

According to a fifth aspect, the present disclosure provides a non-transitory machine-readable medium having stored thereon a program having a program code for performing one of the methods according to the proposed technology, when the program is executed on a processor or a programmable hardware.

According to a fifth aspect, the present disclosure provides a program having a program code for performing one of the methods according to the proposed technology, when the program is executed on a processor or a programmable hardware.

### Brief description of the Figures

Some examples of apparatuses and/or methods will be described in the following by way of example only, and with reference to the accompanying figures, in which
Fig. 1 illustrates a flowchart of an example of a computer-implemented method for comparing a simulation of a physical object with measurement data of the physical object obtained in an experiment;
Fig. 2 illustrates an example of a virtual object;
Fig. 3 illustrates another example of a virtual object;
Fig. 4 illustrates an example of a data flow;
Fig. 5 illustrates a flowchart of an example of a computer-implemented method for generating a finite element representation of measurement data of a physical object obtained in an experiment; and
Fig. 6 illustrates an example of an apparatus for performing one of the methods according to proposed technology.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Same or like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a", "an" and "the" is used and using only a single element is neither explicitly nor implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises", "comprising", "includes" and/or "including", when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

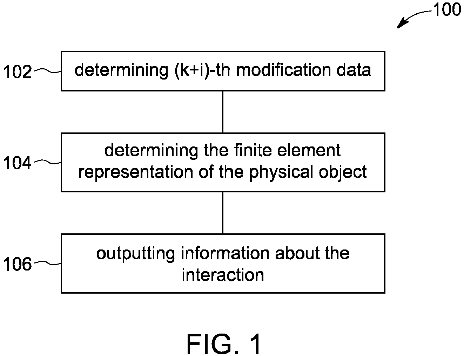

**Fig. 1** illustrates a flowchart of an example of a computer-implemented method 100 for comparing a simulation of a physical object with measurement data of the physical object obtained in an experiment. The simulation of the physical object is an approximate prediction of the operation or behavior of the physical object in the experiment over time. In other words, the simulation approximately predicts the operation or behavior of the physical object in the experiment at a sequence of time steps. For predicting the operation or behavior of the physical object, the evolution over time of one or more quantities of interest characterizing the physical object is predicted by means of the simulation. The physical object may be any object physically present in the real world. For example, the simulation of the physical object may be a simulation of the structural behavior of the physical object or a simulation of a heat flow, a voltage flow, or a current flow through the object. The simulation of the physical object may, e.g., be a simulation of the crash behavior of a physical object such as a vehicle (car) or an aircraft.

For approximately predicting the operation or behavior of the physical object in the experiment over time, the simulation uses a finite element representation of the physical object that may evolve (undergo a modification) over time based on the underlying (e.g. mathematical or physical) model and the used boundary conditions of the simulation.

Further provided for a time step tk of the simulation (k is an integer ≥ 0) is a finite element representation of a virtual object. The virtual object is an imaginary object which is not present in the experiment. The finite element representation of the virtual object is for interacting with the finite element representation of the physical object in order to restrain (limit, restrict) the evolution (modification) of the finite element representation of the physical object in the simulation over time. The time step tk of the simulation may be any time step of the simulation such as an initial time step to of the simulation as well as any subsequent (later) time step of the simulation. The finite element representation of the virtual object for the time step tk may be (e.g. exclusively) user-generated and/or be based on the measurement data of the physical object for the time step tₖ.

For one or more subsequent time steps tₖ₊ᵢ of the simulation (i is an integer > 0), which follow the time step tk of the simulation, the method 100 comprises a step 102 of determining (k+i)-th modification data (i.e. modification data for the time step tₖ₊ᵢ) for nodes of the finite element representation of the virtual object in the time step tₖ₊ᵢ₋₁. The (k+i)-th modification data are determined based on the measurement data of the physical object for the time step tₖ₊ᵢ. The (k+i)-th modification data indicates modifications to data assigned to the nodes of the finite element representation of the virtual object when progressing from the time step tₖ₊ᵢ₋₁ to the time step tₖ₊ᵢ in the simulation. For example, the (k+1)-th modification data indicates modifications to the data assigned to the nodes of the finite element representation of the virtual object when progressing from the time step tk to the time step tk+i in the simulation.

The data assigned to the nodes of the finite element representation of the virtual object is data that characterizes the virtual object at the respective node. For example, the data assigned to the nodes of the finite element representation of the virtual object may be position data indicating positions of the nodes of the finite element representation of the virtual object in a coordinate system of the simulation. However, the data assigned to the nodes of the finite element representation of the virtual object may be other types of data as well. For example, the data assigned to the nodes of the finite element representation of the virtual object may be a (e.g. maximum or minimum) heat, temperature, voltage or current at the positions of the nodes of the finite element representation of the virtual object.

The (k+i)-th modification data may allow to adapt the finite element representation of the virtual object to the measurement data obtained in the experiment. For example, if the data assigned to the nodes of the finite element representation of the virtual object is position data, the (k+i)-th modification data may be modification trajectories for modifying the position data assigned to the nodes of the finite element representation of the virtual object. Additionally, for the one or more subsequent time steps tₖ₊ᵢ of the simulation, the method 100 comprises a step 104 of determining the finite element representation of the physical object for the time step tₖ₊ᵢ based on the finite element representation of the physical object for the time step tₖ₊ᵢ₋₁, the finite element representation of the virtual object for the time step tₖ₊ᵢ₋₁ and the (k+i)-th modification data. Based on the finite element representation of the virtual object for the time step tₖ₊ᵢ₋₁ and the (k+i)-th modification data, the finite element representation of the virtual object for the time step tₖ₊ᵢ may be obtained. Since the (k+i)-th modification data is based on the measurement data of the physical object for the time step tₖ₊ᵢ, the obtained finite element representation of the virtual object for the time step tₖ₊ᵢ takes into account the measurement data of the physical object. Accordingly, when the finite element representation of the physical object evolves from the time step tₖ₊ᵢ₋₁ to the time step tₖ₊ᵢ, the evolution of the finite element representation of the physical object is restrained based on the measurement data of the physical object. In other words, the evolution of the finite element representation of the physical object is restrained to the experimentally observed behavior of the physical object.

For the one or more subsequent time steps tₖ₊ᵢ of the simulation, the method 100 further comprises a step 106 of outputting information about the interaction of the finite element representation of the virtual object with the finite element representation of the physical object. Since the finite element representation of the virtual object is based on the measurement data of the physical object, the interaction of the finite element representation of the virtual object with the finite element representation of the physical object is a measure for the deviation of the finite element representation of the physical object from the experimentally observed behavior of the physical object. In other words, the interaction of the finite element representation of the virtual object with the finite element representation of the physical object is a measure for the quality, validity and/or the predictive power of the simulation.

Accordingly, the method 100 may enable an automated comparison of the experimental observation with the simulation. The method 100 may further enable to provide information about a deviation of the simulation from the experiment, which may be used to identify reasons for the deviation of the simulation from the experiment. Accordingly, the method 100 may allow to provide information that allow to improve the simulation in terms of quality, validity and/or predictive power.

As indicated above, the data assigned to the nodes of the finite element representation of the virtual object may be position data indicating positions of the nodes of the finite element representation of the virtual object in a coordinate system of the simulation. Similarly, the measurement data of the physical object may be position data indicating measured positions of the physical object in the experiment. Accordingly, the positions of the nodes of the finite element representation of the virtual object may be adjusted to (substantially) the positions of the physical object measured in the experiment such that the finite element representation of the virtual object represents the experimentally observed behavior of the physical object. For example, if the simulation of the physical object is a simulation of the crash behavior of the physical object, the measurement data of the physical object may be position data indicating positions of the physical object measured in a crash experiment. Accordingly, the method 100 may enable to compare the simulation of the crash behavior of the physical object to the experimentally observed behavior of the physical object in the crash experiment. The evolution of the finite element representation of the physical object in the simulation of the crash behavior may be restrained to the experimentally observed behavior of the physical object due to the modification of the finite element representation of the virtual object based on the (k+i)-th modification data, which are based on the measured position data obtained in the crash experiment.

The measurement data of the physical object may comprise data of one or more measurement (detector) systems. The measurement data captured by a single measurement systems may be limited (e.g. spatially or temporally incomplete) and not allow to fully describe the behavior of the physical object in the experiment. Therefore, it may be advantageous to combine data of multiple measurement systems using the same or different measurement techniques (e.g. optical two-dimensional or three-dimensional imaging and X-ray imaging). It is to be noted that also the combined data of multiple measurement systems may be limited (e.g. spatially or temporally incomplete). Accordingly, the measurement data of the physical object used in the method 100 may be generated by at least two measurement systems (e.g. measurement systems of different types or measurement systems of the same type).

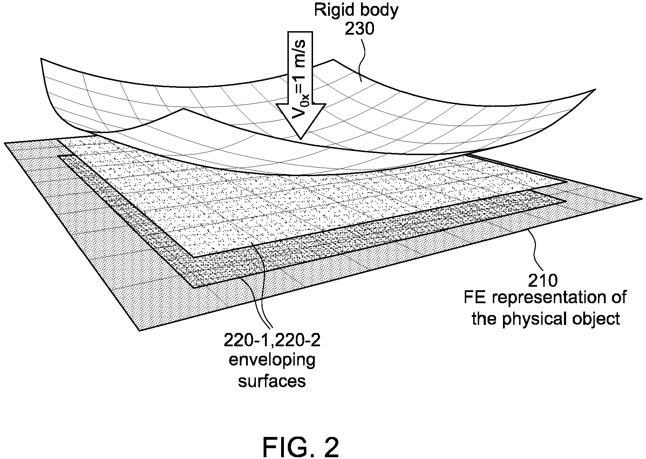

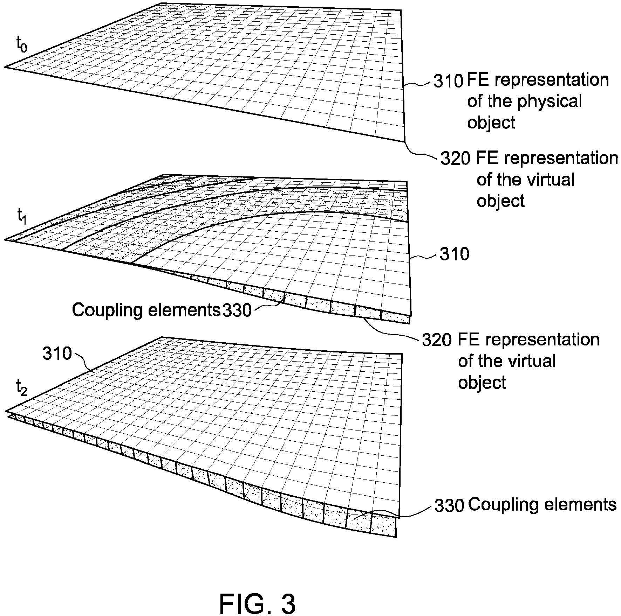

The virtual object used for restraining the evolution of the finite element representation of the physical object may exhibit various shapes and/or structures. Two examples for virtual objects are illustrated in Figs. 2 and 3.

**Fig. 2** illustrates a finite element representation 210 of a physical object together with a finite element representation of a virtual object. In the example of Fig. 2, the virtual object consists of two surfaces enveloping part of the finite element representation 210 of the physical object in the simulation. The finite element representation 210 of the physical object is restricted in the simulation to not penetrate the finite element representation of the virtual object consisting of the two enveloping surfaces 220-1 and 220-2.

As described above, the finite element representation of the virtual object consisting of the two enveloping surfaces 220-1 and 220-2 is based on the measurement data obtained in the experiment. For example, the positions of the nodes of the finite element representation of the virtual object consisting of the two enveloping surfaces 220-1 and 220-2 may be based on measured positions of the physical object in the experiment. Accordingly, the evolution of the finite element representation 210 of the physical object in the simulation may be restricted to substantially the measured positions of the physical object obtained in the experiment. In other words, the finite element representation of the virtual object consisting of the two enveloping surfaces 220-1 and 220-2 may restrict the freedom of movement of the finite element representation 210 of the physical object in the simulation.

The interaction of the finite element representation 210 of the physical object with the finite element representation of the virtual object consisting of the two enveloping surfaces 220-1 and 220-2 may be indicated in various manners. For example, one of the finite element representation 210 of the physical object and the finite element representation of the virtual object consisting of the two enveloping surfaces 220-1 and 220-2 may be colored according to a color code indicating two or more levels of interaction of the finite element representation 210 of the physical object with the finite element representation of the virtual object consisting of the two enveloping surfaces 220-1 and 220-2. In other words, the interaction of the finite element representation 210 of the physical object with the finite element representation of the virtual object consisting of the two enveloping surfaces 220-1 and 220-2 may be represented graphically.

In other examples, a scalar parameter indicating a type and/or a level of interaction of the finite element representation 210 of the physical object with the finite element representation of the virtual object consisting of the two enveloping surfaces 220-1 and 220-2 may be determined. The type of interaction may, e.g., indicate the type of spatial interaction (e.g. punctiform or extensive) or the type of temporal interaction (e.g. short-term or long-term). For example, the scalar parameter may indicate a reaction force such as, e.g., a contact force between the finite element representation 210 of the physical object and the finite element representation of the virtual object consisting of the two enveloping surfaces 220-1 and 220-2. Similarly, the above described color coding may graphically indicate in a spatially resolved manner a reaction force such as, e.g., the contact force between the finite element representation 210 of the physical object and the finite element representation of the virtual object consisting of the two enveloping surfaces 220-1 and 220-2. In other examples, the scalar parameter may indicate a summed-up quantity such as a summed-up force or a summed-up impulse-transfer. The scalar parameter may be spatially and/or timely resolved. In some examples, the scalar parameter may be neither spatially nor timely resolved.

It is to be noted that the two surfaces illustrated in Fig. 2 are merely illustrative. In other examples, the virtual object may be less or more than two surfaces. Further, the one or more surfaces may fully envelope the finite element representation of the physical object in the simulation.

Further illustrated in Fig. 2 is a finite element representation 230 of a rigid body in order illustrate boundary conditions of the experiment in the real world. In the example of Fig. 2, the experiment is a crash experiment in which the rigid body collides with the physical object. Accordingly, the simulation is a simulation of the crash behavior for predicting the behavior of the physical object. By using the finite element representation of the virtual object consisting of the two enveloping surfaces 220-1 and 220-2, the evolution of the finite element representation 210 of the physical object may be restrained to substantially the measured behavior of the physical object in the crash experiment.

**Fig. 3** illustrates an alternative virtual object. In the example of Fig. 3, the virtual object is a virtual replica of the experiment. In other words, the finite element representation 320 of the virtual object is based on the measurement data of the physical object. In particular, the data assigned to the nodes of the finite element representation 320 of the virtual object (e.g. position data indicating positions of the nodes) is derived from the measurement data of the physical object.

Fig. 3 illustrates the finite element representation 320 of the virtual object and the finite element representation 310 of the physical object for three time steps to, t₁ and t₂. The initial time step to is an example for the time step tk mentioned above in the general description of the method 100. For the initial time step to, the finite element representation 310 of the physical object corresponds (coincides) with the finite element representation 320 of the virtual object.

The nodes of the finite element representation 320 of the virtual object are coupled to corresponding nodes of the finite element representation 310 of the physical object via coupling elements 330. The coupling elements 330 are not shown for the initial time step to as the finite element representation 310 of the physical object corresponds (coincides) with the finite element representation 320 of the virtual object.

The coupling elements 330 exhibit coupling coefficients which vary based on the difference between the respective data assigned to coupled nodes. In other words, there is a functional relationship between the coupling coefficients and the difference between the respective data assigned to coupled nodes. The coupling coefficients may, e.g., be linear, non-linear, isotropic, anisotropic, or a combination thereof. That is, a coupling element A coupling a node B of the finite element representation 310 of the physical object with a node C of the finite element representation 320 of the virtual object exhibits a coupling coefficient which varies based on the difference between the respective data assigned to coupled nodes B and C. For example, if the data assigned to nodes of the finite element representation 310 of the physical object and the finite element representation 320 of the virtual object is position data, the coupling element A may exhibit a coupling coefficient that varies based on the difference between the position data assigned to the coupled nodes B and C. In this example, the coupling elements 330 act like virtual (e.g. non-linear) spring couplings that couple the corresponding nodes of the finite element representation 310 of the physical object and the finite element representation 320 of the virtual object in order to restrain the evolution of the finite element representation 310 of the physical object to substantially the measured behavior of the physical object in the crash experiment.

For example, the coupling elements 330 may exert a force on the nodes of the finite element representation 310 of the physical object that (e.g. progressively) increases or decreases based on the respective difference between the position data assigned to coupled nodes of the finite element representation 310 of the physical object and the finite element representation 320 of the virtual object.

The coupling coefficients may, e.g., be determined based on measurement uncertainties of the measurement data underlying the data assigned to the nodes of the finite element representation 320 of the virtual object. Accordingly, the coupling coefficients may be related to the measurement uncertainties. For example, for the same difference between the position data assigned to coupled nodes B and C of the finite element representation 310 of the physical object and the finite element representation 320 of the virtual object, the coupling coefficient of the coupling element A may be small if the measurement data underlying the data assigned to the node C of the finite element representation 320 of the virtual object exhibits a high measurement uncertainty, whereas the coupling coefficient of the coupling element A may be large if the measurement data underlying the data assigned to the node C of the finite element representation 320 of the virtual object exhibits a low measurement uncertainty. The measurement uncertainties of the measurement data may, hence, be taken into account for restraining the evolution of the finite element representation 310 of the physical object.

The coupling elements 330 are illustrated for the time steps ti and t₂ which are subsequent to the time step to. When progressing from the time step to to the time step ti, the finite element representation 320 of the virtual object for the time step to is modified based on first modification data (e.g. first modification trajectories) derived from the measurement data for the time step t₁. The finite element representation 310 of the physical object evolves in the simulation taking into account the coupling to the finite element representation 320 of the virtual object via the coupling elements 330 (e.g. in addition to the one or more boundary conditions of the finite element simulation). In the time step ti, the finite element representation 310 of the physical object no longer coincides with the finite element representation 320 of the virtual object. In other words, the simulation of the physical object slightly deviates for the time step t₁ from the measurement data.

Similarly, when progressing from the time step t₁ to the time step t₂, the finite element representation 320 of the virtual object for the time step t₁ is modified based on second modification data (e.g. second modification trajectories) derived from the measurement data for the time step t₂. The finite element representation 310 of the physical object evolves in the simulation taking into account the coupling to the finite element representation 320 of the virtual object via the coupling elements 330 (e.g. in addition to the one or more boundary conditions of the finite element simulation). Like for the time step ti, the finite element representation 310 of the physical object slightly deviates from the finite element representation 320 of the virtual object for the time step t₂.

Similar to what is described above with respect to Fig. 2 for the finite element representation of the virtual object consisting of the two enveloping surfaces 220-1 and 220-2, also the interaction of the finite element representation 310 of the physical object with the finite element representation 320 of the virtual object via the coupling elements 330 may be indicated in various manners. For example, one of the finite element representation 310 of the physical object and the finite element representation 320 of the virtual object may be colored according to a color code indicating two or more levels of interaction of the finite element representation 310 of the physical object with the finite element representation 320 of the virtual object via the coupling elements 330. In other examples, a scalar parameter indicating a type and/or a level of interaction of the finite element representation 310 of the physical object with the finite element representation 320 of the virtual object via the coupling elements 330 may be determined.

The virtual objects illustrated in Figs. 2 and 3 may allow to limit the possible solutions (i.e. the solution corridor) for the finite element representation 310 of the physical object when evolving from one time step to another. It is to be noted that the proposed technology is not limited to the specific virtual objects illustrated in Figs. 2 and 3 and that other virtual objects may be used as well.

Referring back to Fig. 1, the step 102 of determining the (k+i)-th modification data will be described with more details in the following.

First, an estimate for the finite element representation of the physical object for the time step tₖ₊ᵢ is determined. The estimate for the finite element representation of the physical object is an approximation of the finite element representation of the physical object for the time step tₖ₊ᵢ.

Subsequently, the measurement data of the physical object for the time step tₖ₊ᵢ are allocated to corresponding nodes of the estimate. In other words, the measurement data of the physical object for the time step tₖ₊ᵢ are assigned to the nodes of the estimate. For example, each measurement position in the experiment for which a measurement value is obtained may be allocated to a respective node of the estimate.

Further, deviations are determined between the measurement data of the physical object for the time step tₖ₊ᵢ and data assigned to the allocated nodes of the estimate for the time step tₖ₊ᵢ. The data assigned to the allocated nodes of the estimate for the time step tₖ₊ᵢ is of the same type as the data assigned to the nodes of the finite element representation of the physical object for the time step tₖ₊ᵢ₋₁ (e.g. position data). That is, deviations between the estimated data for the finite element representation of the physical object and the related measured values of the experiment are determined for the time step tₖ₊ᵢ.

In addition, distances between the nodes of the estimate of the physical object for the time step tₖ₊ᵢ are determined. For example, the distances between the nodes of the estimate may be Euclidean distances or geodesic distances (the shortest distances along the object geometry). However, it is to be noted that also other types of distances may be used.

The deviations and the distances between the nodes of the estimate are used for generating virtual measurement data for the physical object for the time step tₖ₊ᵢ. As described above, the measurement data for the physical object for the time step tₖ₊ᵢ obtained in the experiment may be incomplete as, e.g., the resolution and/or the part of the physical object observable by the measurement system(s) may be limited. Accordingly, the generation of virtual measurement data may allow to complement or supplement the measured data. The virtual measurement data for the physical object for the time step tₖ₊ᵢ are determined by interpolating the previously determined deviations between the measurement data of the physical object for the time step tₖ₊ᵢ and the data assigned to the allocated nodes of the estimate for the time step tₖ₊ᵢ using the estimate for the finite element representation of the physical object for the time step tₖ₊ᵢ and the distances between the nodes of the estimate for the finite element representation of the physical object for the time step tₖ₊ᵢ. In other words, the experimental observations are complemented by interpolating the observed deviations between the measurement data of the physical object for the time step tₖ₊ᵢ and the data assigned to the allocated nodes of the estimate for the time step tₖ₊ᵢ based on the results of the above described sub-steps of step 102 for determining the (k+i)-th modification data.

The interpolation may be done in many different ways. For example, deterministic or geostatistical interpolation methods may be used. Examples for deterministic interpolation methods are inverse distance weighted interpolation, polynomial interpolation, spline interpolation or interpolation based on radial basis functions. For geostatistical interpolation, a kriging method (also known as Gaussian process regression) may be used. According to some example, machine-learning methods may be used for interpolation.

The (k+i)-th modification data are then subsequently determined based on the measurement data of the physical object for the time step tₖ₊ᵢ (obtained in the experiment) and the virtual measurement data for the time step tₖ₊ᵢ.

If the virtual object is at least one surface enveloping at least part of the finite element representation of the physical object in the simulation (as exemplarily illustrated in Fig. 2), determining the (k+i)-th modification data based on the measurement data of the physical object and the virtual measurement data for the time step tₖ₊ᵢ comprises determining a finite element representation of the experiment for the time step tₖ₊ᵢ based on the measurement data of the physical object for the time step tₖ₊ᵢ and the virtual measurement data for the time step tₖ₊ᵢ. The finite element representation of the experiment for the time step tₖ₊ᵢ is based on the measurement data of the physical object for the time step tₖ₊ᵢ obtained in the experiment and is complemented with the virtual measurement data for the time step tₖ₊ᵢ. The finite element representation of the experiment for the time step tₖ₊ᵢ is a complemented representation of the experimental state of the physical object for the time step tₖ₊ᵢ.

Further normal vectors for the nodes of the finite element representation of the experiment for the time step tₖ₊ᵢ are determined. The normal vectors are orthogonal to the finite element representation of the experiment for the time step tₖ₊ᵢ.

In case the virtual object is at least one surface enveloping at least part of the finite element representation of the physical object in the simulation, the (k+i)-th modification data is determined based on the finite element representation of the experiment for the time step tₖ₊ᵢ and the normal vectors for the nodes of the finite element representation of the experiment for the time step tₖ₊ᵢ. For determining the (k+i)-th modification data based on the finite element representation of the experiment for the time step tₖ₊ᵢ and the normal vectors for the nodes of the finite element representation of the experiment for the time step tₖ₊ᵢ, uncertainties of the virtual measurement data for the time step tₖ₊ᵢ are determined based on the measurement uncertainties of the measurement data of the physical object for the time step tₖ₊ᵢ. For example, the uncertainties of the virtual measurement data for the time step tₖ₊ᵢ may be determined during the interpolation. The uncertainties of the virtual measurement data for the time step tₖ₊ᵢ may firstly originate from the measurement uncertainties of the measurement data of the physical object for the time step tₖ₊ᵢ as they are derived therefrom, and secondly from the interpolation process as the interpolation adds additional uncertainties and/or interpolation errors.

Subsequently, an auxiliary finite element representation of the virtual object for the time step tₖ₊ᵢ is determined based on the finite element representation of the experiment for the time step tₖ₊ᵢ and the normal vectors for the nodes of the finite element representation of the experiment for the time step tₖ₊ᵢ. For determining the auxiliary finite element representation of the virtual object for the time step tₖ₊ᵢ a predetermined metric for converting the uncertainties of the virtual measurement data and the measurement uncertainties of the measurement data of the physical object for the time step tₖ₊ᵢ to scalar values of the same type as the measurement data of the physical object is used. For example, if the measurement data of the physical object is position data, the predetermined metric may be for converting the uncertainties of the virtual measurement data and the measurement uncertainties of the measurement data of the physical object for the time step tₖ₊ᵢ to scalar distance values.

This auxiliary finite element representation of the virtual object for the time step tₖ₊ᵢ is used for determining the (k+i)-th modification data, In particular, the (k+i)-th modification data is determined based on a comparison of the auxiliary finite element representation of the virtual object for the time step tₖ₊ᵢ and the finite element representation of the virtual object for the time step tₖ₊ᵢ₋₁. For example, the data assigned to corresponding nodes of the auxiliary finite element representation of the virtual object for the time step tₖ₊ᵢ and the finite element representation of the virtual object for the time step tk+i-i may be compared in order to determine the (k+i)-th modification data. If the data assigned to the nodes of the finite element representation of the virtual object is position data indicating positions of the nodes of the finite element representation of the virtual object, the (k+i)-th modification data may be modification trajectories indicating the difference between the positions assigned to corresponding nodes of the auxiliary finite element representation of the virtual object for the time step tₖ₊ᵢ and the finite element representation of the virtual object for the time step tₖ₊ᵢ₋₁.

Accordingly, the modification to the solution corridor restraining the evolution of the finite element representation of the physical object may be determined for the time step tₖ₊ᵢ.

If the virtual object is a virtual replica of the experiment for the time step tₖ (as exemplarily illustrated in Fig. 3), determining the (k+i)-th modification data based on the measurement data of the physical object and the virtual measurement data for the time step tₖ₊ᵢ comprises determining a finite element representation of the experiment for the time step tₖ₊ᵢ based on the measurement data of the physical object and the virtual measurement data for the time step tₖ₊ᵢ similarly to what is described above for the virtual object being one or more surfaces enveloping at least part of the finite element representation of the physical object in the simulation. The finite element representation of the experiment for the time step tₖ₊ᵢ is a complemented representation of the experimental state of the physical object for the time step tₖ₊ᵢ.

In case the virtual object is a virtual replica of the experiment for the time step tk, the (k+i)-th modification data is determined based on a comparison of the finite element representation of the experiment for the time step tₖ₊ᵢ and the finite element representation of the virtual object for the time step tₖ₊ᵢ₋₁. For example, if the data assigned to the nodes of the finite element representation of the virtual object is position data indicating positions of the nodes of the finite element representation of the virtual object, the (k+i)-th modification data may be modification trajectories indicating the difference between the positions assigned to corresponding nodes of the finite element representation of the experiment for the time step tₖ₊ᵢ and the finite element representation of the virtual object for the time step tₖ₊ᵢ₋₁.

Accordingly, the modification to the solution corridor restraining the evolution of the finite element representation of the physical object may be determined for the time step tₖ₊ᵢ.

Further, uncertainties of the virtual measurement data for the time step tₖ₊ᵢ are determined based on the measurement uncertainties of the measurement data of the physical object for the time step tₖ₊ᵢ. For example, the uncertainties of the virtual measurement data for the time step tₖ₊ᵢ may be determined during the interpolation. The uncertainties of the virtual measurement data for the time step tₖ₊ᵢ may firstly originate from the measurement uncertainties of the measurement data of the physical object for the time step tₖ₊ᵢ as they are derived therefrom, and secondly from the interpolation process as the interpolation adds additional uncertainties and/or interpolation errors.

The measurement uncertainties of the measurement data and the uncertainties of the virtual measurement data are taken into account by means of the coupling coefficients which couple the nodes of the finite element representation of the virtual object to corresponding nodes of the finite element representation of the physical object. In particular, the coupling coefficients are determined based on the measurement uncertainties of the measurement data and the uncertainties of the virtual measurement data underlying the data assigned to the nodes of the finite element representation of the virtual object.

The above described determination of the estimate for the finite element representation of the physical object for the time step tₖ₊ᵢ may be done in various ways. Two examples will be described in the following.

For example, the finite element representation of the physical object for the time step tₖ₊ᵢ₋₁ may be combined with (k+i)-th auxiliary modification data. The (k+i)-th auxiliary modification data indicates modifications of the data assigned to the nodes of the finite element representation of the physical object from the time step tₖ₊ᵢ₋₁ to the time step tₖ₊ᵢ in the simulation when the finite element representation of the virtual object is omitted. In other words, the (k+i)-th auxiliary modification data describes the difference between the data assigned to the nodes of the finite element representation of the physical object from the time step tₖ₊ᵢ₋₁ to the time step tₖ₊ᵢ in the simulation in case the finite element representation of the virtual object is not used. For example, if the data assigned to the nodes of the finite element representation of the physical object is position data indicating positions of the nodes of the finite element representation of the physical object, the (k+i)-th auxiliary modification data may be modification trajectories indicating the difference between the positions of the nodes of the finite element representation of the physical object when evolving from the time step tₖ₊ᵢ₋₁ to the time step tₖ₊ᵢ. Using the "untouched" simulation not taking into account the finite element representation of the virtual object may allow to obtain a projection of the finite element representation of the physical object for the time step tₖ₊ᵢ.

Alternatively, the finite element representation of the experiment for the time step tₖ₊ᵢ₋₁ may be combined with the (k+i)-th auxiliary modification data. In this example, the finite element representation of the physical object for the time step tk+i-i which is calculated considering the dynamic solution corridor is not used. The estimate of the finite element representation of the physical object for the time step tₖ₊ᵢ is based on the complemented experimental observation but not on the simulation for the time step tₖ₊ᵢ₋₁, which is restrained by the finite element representation of the virtual object.

It is to be noted that the estimate for the finite element representation of the physical object for the time step tₖ₊ᵢ may as well be determined differently. For example, the above examples may be combined such that the finite element representation of the physical object is for one or more time steps tₖ₊ᵢ based on the complemented experimental observation and on the simulation for the respective previous time step tₖ₊ᵢ₋₁ (which is restrained by the finite element representation of the virtual object), and is for one or more further time steps tₖ₊ᵢ based on the complemented experimental observation but not on the simulation for the respective previous time step.

As described above, the information about the interaction of the finite element representation of the virtual object with the finite element representation of the physical object may be used to compare the simulation to the measurement data obtained in the experiment or to the results of another simulation. For example, the simulation may be validated using the measurement data obtained in the experiment. Further, the information about the interaction of the finite element representation of the virtual object with the finite element representation of the physical object is a physically based and interpretable data set that describes discrepancies between the measurement data and the simulation results. This piece of information may be used for identifying potential roots of the discrepancies.

The information about the interaction of the finite element representation of the virtual object with the finite element representation of the physical object may further be used for other evaluation (assessment) tasks. In other example, the finite element representation of the physical object for the time step tₖ₊ᵢ obtained according to the method 100 may be compared to another finite element representation of the physical object for the time step tₖ₊ᵢ obtained when omitting the finite element representation of the virtual object. For example, stress/strain states or geometries may be compared.

Additionally, assuming that the above described simulation of the physical object is one of a plurality of simulations of the physical object, the information about the interaction of the finite element representation of the virtual object with the finite element representation of the physical object may be used for comparison to the other ones of the plurality of simulations of the physical object (or at least part thereof). The underlying (e.g. mathematical or physical) model and/or the boundary conditions of the other ones of the plurality of simulations of the physical object may vary. The other simulations are similarly restrained by means of a respective finite element representation of a virtual object. Further, also for the other simulations a respective information about the interaction of the respective finite element representation of the virtual object with the respective finite element representation of the physical object is determined.

The information about the interaction of the finite element representation of the virtual object with the finite element representation of the physical object determined for the simulation may, e.g., be compared with (to) the information about the interaction of the finite element representation of the virtual object with the finite element representation of the physical object determined for the other simulations of the plurality of simulations in order to obtain a comparison result. Based on the comparison result, the simulation among the plurality of simulations that matches the measurement data of the physical object best may, e.g. be determined.

However, it is to be noted that also other criteria may be evaluated using the information about the interaction of the finite element representation of the virtual object with the finite element representation of the physical object determined for the plurality of simulations.

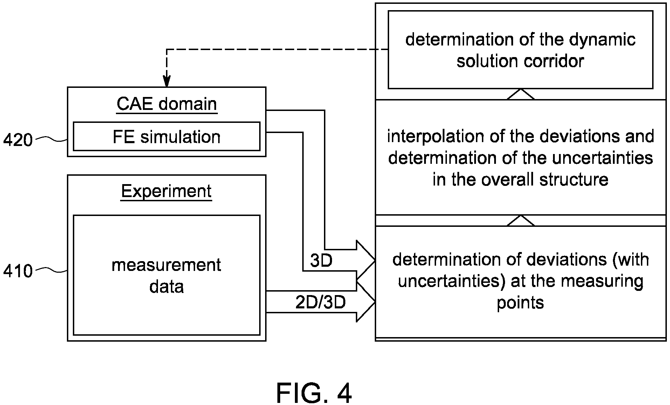

In the following, the above principles of the proposed technology will be described with respect to another example. The following paragraphs in connection with Fig. 4 illustrate the proposed technology from another point of view. As described above, the proposed technology may enable an automated and integrated processing of incomplete measurement data of any measurement system(s). The measurement data may be subject to uncertainties and of various spatial and/or temporal resolutions. The proposed technology may further allow to generate data describing deviations between experiment and finite element simulation as well as a full finite element representation of the experiment.

As described above in detail, the proposed technology generates a dynamic solution corridor based on the experimental observations of one or more measurement systems. The solution corridor may be continuously fed back into the Computer-Aided Engineering (CAE) domain of the simulation. As described above, the continuous feedback of the solution corridor into the CAE environment may enable to identify and evaluate deviations between the experiment and simulation. A further advantage of the propose technology is the complementation of measurement data of the next time step using the simulation, which is restrained to the generated solution corridor.

A corresponding data flow is illustrated in Fig. 4. The measurement data 410 of the experiment (e.g. two-dimensional and/or three-dimensional measurement data) is combined with the data 420 of the finite element simulation from the CAE domain in order to complement the measurement data 410. For example, incomplete geometrical measurement data of different measurement systems with different resolutions may be combined with the prediction of the simulation in order to complement the measurement data. As indicated in Fig. 4, deviations between the measurement data 410 and the prediction of the finite element simulation are determined together with corresponding uncertainties before the deviations are interpolated using interpolation methods such as geostatistical methods like kriging or machine learning methods. Accordingly, complemented measurement data may be obtained.

In order to be able to identify deviations between the simulation and the experiment, and to complement the measurement data over the whole time range of the simulation, the complemented measurement data is continuously fed back into the CAE domain. As exemplarily described above, the feedback may be done using virtual objects such as one or more enveloping surfaces which restrain the freedom of movement of the fine element representation of the physical object (e.g. see Fig. 2).

The proposed technology is combination of white-box (deterministic) elements and black-box (data based) elements, which may be denoted as a "Grey-Box-Processing". The Grey-Box-Processing according to the proposed technology may enable generation of spatially and timely resolved data sets that enable a physically interpretable description of the deviations between the simulation and the experiment. The physically interpretable description of the deviations between the simulation and the experiment may enable identification of reasons (roots) for the deviations. As described above, the data sets may be generated based on the interaction of the finite element representation of the physical object with the solution corridor that are, e.g., represented by the finite element representations of the enveloping surfaces. For example, reaction forces such as contact force between the finite element representation of the physical object and the finite element representation of the enveloping surfaces may, e.g., be represented as part of a post-processing such as a function of time on the finite element representations by means of color coding. Further, these forces may be represented by scalar values, which may be understood as figures of merit. For example, a momentum transfer between the finite element representation of the physical object and the finite element representation of an enveloping surface in a selected area may be represented for a selected time. Such figures of merit may allow to identify reasons for the deviations of the simulation from the experiment. Further, such figures of merit may allow to assess the conformity of plural simulations with different experiments. Further, the finite element representation of the experiment obtained in the Grey-Box-Processing according to the proposed technology may be used for various further evaluation (assessment) tasks.

For example, the proposed technology may be used for geometric measurement data and corresponding uncertainties of an arbitrary number of measurement systems with arbitrary spatial and/or temporal resolution. Further, one or more corresponding finite element simulations for the process observed in the experiment may be used.

An exemplary workflow in accordance with the principles of the above described method 100 may be as follows for a simulation in which position data is assigned to the nodes of the respective finite element representations, which indicate the positions of the nodes of the respective finite element representations:
1) Determining an estimate of the simulation value (i.e. an estimate of the finite element representation of the physical object) for a time step tₖ₊ᵢ based on, e.g., the node trajectories of the initial simulation (i.e. a simulation omitting/not using the finite element representation of the virtual object for restraining the evolution of the finite element representation of the physical object) from a time step tₖ₊ᵢ₋₁ to the time step tₖ₊ᵢ.
2) Determining spatial deviations between the projected finite element simulation values (i.e. the estimate of the finite element representation of the physical object) and the estimate values of the experiment at the nodes of the finite element simulation, which correspond to the experimental observations (i.e. the measurement data of the experiment) for the time step tₖ₊ᵢ. The measurement points in the experiment are previously allocated to the nodes of the finite element simulation.
3) Determining the distances between all finite element nodes based on the result of step 1). In other words, the distances between the nodes of the estimate of the finite element representation of the physical object are determined. For example, Euclidean distances or geodesic distances may be determined.
4) Complementing the experimental observations by interpolation the determined spatial deviations based on the results of steps 1), 2) and 3). For example, a kriging method, a machine-learning method, or any other interpolation method may be used (see above for further examples).
5) Determining normal vectors on a finite element mesh resulting from the results of the steps 1), 2) and 4). The finite element mesh resulting from the results of the steps 1), 2) and 4) corresponds to the finite element representation of the experiment described above.
6) Defining an (eventually problem-specific) metric for converting the measurement uncertainties and uncertainties resulting from the interpolation into a geometric distance of the enveloping surfaces (which defines the "width" of the solution corridor). In other words, the metric is defined for converting the uncertainties of the virtual measurement data and the measurement uncertainties of the measurement data of the physical object to distance values as described above.
7) Initial definition of the enveloping surfaces (for defining the solution corridor) by generating a corresponding finite element mesh for the time step to (being an example for the finite element representation of the virtual object for the time step tk described above).
8) Defining the trajectories for the dynamic solution corridor for the next time step tₖ₊ᵢ that follows the current time step tₖ₊ᵢ₋₁. In this respect, the results of steps 1), 2), 4), 5) and 6) are converted to trajectories for the nodes of the virtual enveloping surfaces (which is a specific example for (k+i)-th modification data as described above).
9) Starting a new simulation from the time step to to the time step t₁ using the dynamic solution corridor. In other words, the finite element representation of the physical object for the time step t₁ is determined based on the finite element representation of the physical object for the time step to, the finite element representation of the virtual object for the time step t₀ and the (k+i)-th modification data as described above (with k = 0 and i = 1 for progressing from the time step to to the time step ti).
10) Repeating the steps 1), 2), 3), 4), 5) and 8) based on the results of the new simulation performed in step 9) in order to determine new trajectories for the dynamic solution corridor. In other words, (k+i)-th modification data for progressing from the time step t₁ to the time step t₂ is determined as described above (i.e. with k = 0 and i = 2 for progressing from the time step t₁ to the time step t₂).
11) The new simulation of step 9) is continued for progressing from the time step t₁ to the time step t₂ using the new trajectories for the dynamic solution corridor as determined in step 10). In other words, the finite element representation of the physical object for the time step t₂ is determined based on the finite element representation of the physical object for the time step ti, the finite element representation of the virtual object for the time step t₁ and the 2^{nd} modification data as described above. The finite element representation of the virtual object for the time step t₁ is combined with the (k+i)-th modification data in order to obtain the finite element representation of the virtual object for the time step t₂.
12) Repeating the steps 10) and 11) until the maximum (final) time step tₘₐₓ of the simulation is reached.
13) Post-processing of the data sets generated in steps 1) to 12) by, e.g.:
   - visualizing interactions between the enveloping surfaces and the observed object as a function of time by color coding the enveloping surfaces; or
   - other evaluations of the interactions such as definition of a (e.g. scalar) figure of merit for evaluating the correspondence between the simulation and the experiment; or
   - identifying the simulation having the highest correspondence with the experiment among a plurality of simulations
   - other comparative analyses based on the generated, complemented three-dimensional finite element representation of the experiment.

The examples described in step 13) are specific examples of the information about the interaction of the finite element representation of the virtual object with the finite element representation of the physical object described above.

The above exemplary workflow may, e.g., be modified by omitting the continuous feedback of the dynamic solution corridors similar to what is described above. For example, the steps 1), 2), 3), 4) and 5) may be performed for the whole simulation time range (i.e. up to the time step tₘₐₓ). In this example, the determination of the estimate of the simulation value for the time step tₖ₊ᵢ in step 1) is based on the result of the complemented experimental observation in step 4) and not based on the results of the new simulation using the dynamic solution corridor (above steps 9) and 11)). In other words, the finite element representation of the experiment for the time step tₖ₊ᵢ₋₁ is combined with the (k+i)-th auxiliary modification data.

The determination of the dynamic solution corridor as well as the usage of the solution corridor in the new simulation and the generation and usage of the physically interpretable data sets for the experimental observation is done subsequently for the whole simulation time range (i.e. up to the time step tₘₐₓ) and comprises the steps 6), 7), 8), 9), 11) and 13).

As described above in more general terms for the method 100, the feedback of the complemented experimental observations into the finite element simulation is not restricted to the above described enveloping surfaces. Instead of the enveloping surfaces, a reference geometry in the form of a finite element representation of a virtual replica of the experiment may be used. The nodes of this finite element mesh correspond to the estimated values of the complemented experimental observation. The nodes of the virtual reference geometry are coupled to the corresponding nodes of the finite element representation of the physical object. A shift of a node of the finite element representation of the physical object that does not coincide with a shift of the corresponding node of the virtual reference geometry causes restoring forces towards the virtual reference geometry. For example, these restoring forces may develop progressively (e.g. increase) for increasing distances between coupled nodes. The progressive development of the restoring forces may be correlated with the uncertainties of the complemented experimental observations. According, for nodes with low uncertainties, the restoring forces are higher for the same spatial deviation compare to nodes with higher uncertainties. The definition of the restoring forces may be spatially resolved and directional dependent. The virtual reference geometry is an alternative way for implementing the solution corridor.

Regarding the above exemplary workflow with the steps 1) to 13), the following modifications may apply when using the virtual reference geometry instead of the enveloping surfaces:
Step 5): is omitted
Step 6): Defining an (eventually problem-specific) metric for converting the measurement uncertainties and uncertainties resulting from the interpolation into a progression of the distance dependent restoring forces. In other words, the metric is defined for converting the uncertainties of the virtual measurement data and the measurement uncertainties of the measurement data of the physical object to corresponding coupling coefficients.
Step 7): Initial definition of the virtual reference geometry (for defining the solution corridor) by generating a corresponding finite element mesh for the time step to.
Step 8): Defining the trajectories for the dynamic solution corridor for the next time step tₖ₊ᵢ that follows the current time step tₖ₊ᵢ₋₁. In this respect, the results of steps 1), 2), and 4) are converted to trajectories for the nodes of the virtual reference geometry (which is a specific example for (k+i)-th modification data as described above).
Step 9): Starting a new simulation from the time step to to the time step t₁ using the virtual reference geometry.
Step 11): The new simulation of step 9) is continued for progressing from the time step t₁ to the time step t₂ using the new trajectories for the virtual reference geometry as determined in step 10).
Step 12): Repeating the steps 10) and 11) until the maximum (final) time step tₘₐₓ of the simulation is reached.
Step 13): Post-processing of the generated data sets by, e.g.:
   - visualizing the restoring forces; or
   - other evaluations of the restoring forces or energies such as definition of a (e.g. scalar) figure of merit for evaluating the correspondence between the simulation and the experiment; or
   - identifying the simulation having the highest correspondence with the experiment among a plurality of simulations
   - other comparative analyses based on the generated, complemented three-dimensional finite element representation of the experiment.

Similar to what is described above for the enveloping surfaces, the continuous feedback of the dynamic solution corridor may be omitted. That is, the determination of the estimate of the simulation value for the time step ti+i in step 1) may be based on the result of the complemented experimental observation in step 4) and not be based on the results of the new simulation using the dynamic solution corridor (above steps 9) and 11)). Further, other parameters such as the used interpolation method may be varied. Further, the generated data sets may be used differently from what is described for step 13).

The above described complementation of the experimental observations by means of interpolating the deviations between the experiment and the simulation is one aspect of the integral method according to the proposed technology. The complementation is based on estimated simulation values, determined deviations at the nodes of the finite element simulation from the associated measurement values and the information about the distances between the nodes of the finite element mesh as described above. This approach enables combined processing of measurement data from various (e.g. plural different) measurement systems with a large variation in terms of spatial resolution and temporal resolution. This approach may enable to close spatial and/or temporal observation gaps. Further, the potential of complementary information provided by different measurement systems may be used to a greater extent. For example, the simulation may be validated according to the proposed technology by combining measurement data obtained via one or more measurement techniques such as x-ray measurements, optical measurement techniques using target marks and/or statistical patterns or optical three-dimensional measurements using Gobo projections (i.e. a projected pattern). By capturing punctiform information (e.g. by means of markers for x-ray measurements) in areas not visible for the optical three-dimensional measurement and subsequent application of the proposed technology, a complementation of the measurement data may be achieved.

The transformation of the complemented experimental observations (estimate and uncertainties) into a dynamic solution corridor and the subsequent feedback of the solution corridor into the finite element simulation by means of the virtual objects (e.g. enveloping surfaces or virtual replica of the experiment) leads to a restraint of the observed finite element structure to the experimentally observed behavior of the real physical structure. This may be advantageous for various reasons. For example, physically interpretable interactions between the virtual object and the finite element representation of the physical object may be observed. These physically interpretable interactions may allow to identify and quantify the deviations of the simulation from the experiment and, hence, be used for identifying reasons for this deviation. Further, a finite element representation of the experiment may be provided that may be used for further comparisons of the simulation to the experiment.

The continuous feedback of the experimental observations into the finite element domain in the form of the temporally closed information flow illustrated in Fig. 4 may allow to determine the deviation of the simulation from the experiment for a time step tₖ₊ᵢ by means of the estimated simulation value, which takes into account an updated simulation value based on the experimental observation for the time step tₖ₊ᵢ₋₁. The continuous feedback of the experimental observations may enable the complementation of the measurement data over the whole time range of the simulation (even for larger discrepancies between the simulation and the experiment). For example, also for bifurcations due to crash kinematics, the proposed technology may enable the identification and evaluation of the discrepancies between the simulation and the experiment over the whole time range of the simulation.

Since the restraint of the kinematics of the observed physical object in the simulation depends on the uncertainties of the complemented experimental observations, the finite element structure is restrained only within the level of confidence with respect to the measurements and the interpolations. The measurement uncertainties are directly processed by the proposed method and therefore need not be taken into account and interpreted separately when validating the simulation.

During post-processing, a timely resolved, color coded visualization of the interaction between the simulation and the virtual object (e.g. enveloping surfaces or virtual replica of the experiment) on the virtual object may be obtained. Accordingly, a spatially and timely resolved identification and quantification of deviations of the simulation from the experiment may be obtained. The spatially and timely resolved identification and quantification of the deviations may allow to further identify reasons for the deviations and, hence, allow determination of suitable countermeasures in the virtual domain of the simulation and/or the real-world domain.

As described above, the definition of scalar values serving as figures of merit may be based on the spatially and timely resolved identification and quantification of the deviations. This may allow to provide a measure for the conformity of the simulation with the experiment.

Further, the method may allow comparison of plural simulations to the experiment in order to check for the conformity of the plurality of simulations with the experiment. By identifying simulations with high conformity to the experiment and analyzing the boundary conditions of these simulations, insights on the deviations between simulation and experiment may be gathered. This process and the results obtained therefrom may allow for a fully automated validation and optimization of finite element structures.

As described above, one aspect of the proposed technology is the complementation of measurement data obtained in an experiment. In the above paragraphs, the complementation of measurement data is described as part of the proposed method for comparing a simulation of a physical object with measurement data of the physical object obtained in an experiment. However, it is to be noted that the complementation of measurement data is not restricted to the above described application. In general, the proposed complementation of measurement data may also be used independent of the proposed method for comparing a simulation with measurement data obtained in an experiment.

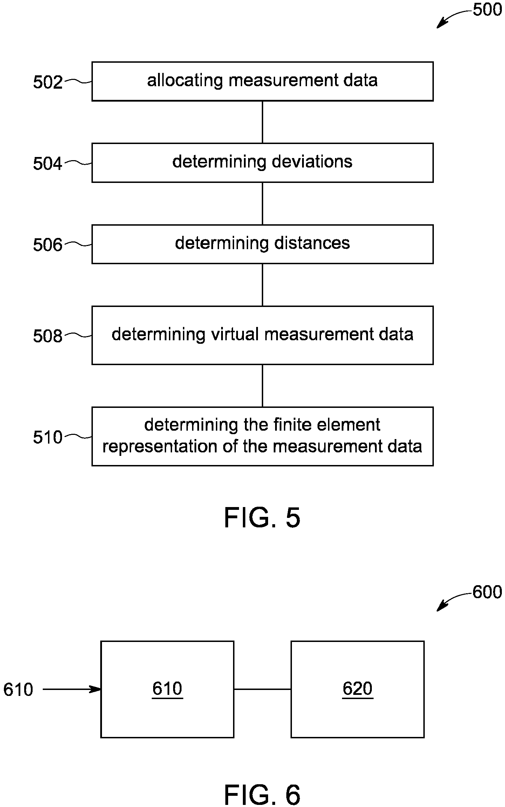

In order to further emphasize this aspect of the proposed technology, Fig. 5 illustrates a flowchart of an example of a computer-implemented method 500 for generating a finite element representation of measurement data of a physical object obtained in an experiment.

The method 500 comprises a step 502 of allocating the measurement data of the physical object to nodes of a finite element representation of the physical object similar to what is described above. In other words, the measurement data of the physical object is assigned to the nodes of the finite element representation of the physical object. For example, each measurement position in the experiment for which a measurement value is obtained may be allocated to a respective node of the finite element representation of the physical object.

Further, the method 500 comprises a step 504 of determining deviations between the measurement data of the physical object and data assigned to the allocated nodes of the finite element representation of the physical object similar to what is described above. That is, deviations between the data for the finite element representation of the physical object and the related measured values of the experiment are determined. The data assigned to the allocated nodes of the finite element representation of the physical object is of the same type as the measurement data. For example, the measurement data of the physical object may be position data indicating positions of the physical object measured in the experiment (e.g. a crash experiment), and the data assigned to the nodes of the finite element representation of the physical object may be position data indicating positions of the nodes of the finite element representation of the physical object.

The method 500 comprises a step 506 of determining distances between the nodes of the finite element representation of the physical object. For example, the distances between the nodes of the estimate may be Euclidean distances or geodesic distances (the shortest distances along the object geometry). However, it is to be noted that also other types of distances may be used.

Additionally, the method 500 comprises a step 508 of determining virtual measurement data for the physical object by interpolating the deviations based on the finite element representation of the physical object and the distances between the nodes of the finite element representation of the physical object. As described above, the measurement data for the physical object obtained in the experiment for a certain time step may be incomplete as the resolution and/or the part of the physical object observable by the measurement system(s) may be limited. Accordingly, the generation of virtual measurement data may allow to complement or supplement the measured data. In other words, the experimental observations are complemented by interpolating the observed deviations between the measurement data of the physical object and data assigned to the allocated nodes of the finite element representation of the physical object. The interpolation may be done in many different ways. For example, one of the above described deterministic interpolation methods, the geostatistical interpolation methods (e.g. a kriging method) or machine learning method may be used.

Further, the method 500 comprises a step 510 of determining the finite element representation of the measurement data based on the measurement data for the physical object and the virtual measurement data for the physical object. The finite element representation of the measurement data is based on the measurement data of the physical object obtained in the experiment and is complemented with the determined virtual measurement data. The finite element representation of the measurement data is a complemented representation of the experimental state of the physical object for a certain time step. In other words, the finite element representation of the measurement data obtained in step 510 is a complemented finite element representation of the experimental state of the physical object for a certain time step.

Accordingly, the method 500 may allow to generate a finite element representation of the experiment that may be used for various tasks such as comparisons of simulations to the experiment.

Further details and aspects of method 500 are mentioned in connection with the proposed technique or one or more examples described above (e.g. Figs. 1 to 3). The method may comprise one or more additional optional features corresponding to one or more aspects of the proposed technique or one or more examples described above.

An example of an apparatus 600 for comparing a simulation of a physical object with measurement data of the physical object obtained in an experiment or for generating a finite element representation of measurement data of a physical object obtained in an experiment according to the proposed technology is illustrated in **Fig. 6****.**

The apparatus 600 comprises an input interface 610 (e.g. implemented as a hardware circuit or as a software interface) configured to receive the measurement data 601 of the physical object. For example, the input interface 610 may be coupled to one or more measurement (detector) systems used in the experiment for observing the behavior of the physical object. Alternatively, the input interface 610 may be coupled to a data storage storing the measurement data 601.

The apparatus 600 further comprises a processing circuit 620. For example, the processing circuit 620 may be a single dedicated processor, a single shared processor, or a plurality of individual processors, some of which or all of which may be shared, a digital signal processor (DSP) hardware, an application specific integrated circuit (ASIC) or a field programmable gate array (FPGA). The processing circuit 620 may optionally be coupled to, e.g., read only memory (ROM) for storing software, random access memory (RAM) and/or non-volatile memory. The processing circuit 620 is configured to perform processing according to the above described technique for comparing a simulation of a physical object with measurement data of the physical object obtained in an experiment or for generating a finite element representation of measurement data of a physical object obtained in an experiment.

The apparatus 600 may further comprise further hardware - conventional and/or custom.

The aspects and features mentioned and described together with one or more of the previously detailed examples and figures, may as well be combined with one or more of the other examples in order to replace a like feature of the other example or in order to additionally introduce the feature to the other example.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in non-transitory machine readable medium (e.g. a floppy disc, a DVD, a Blu-Ray, a CD, a ROM, a PROM, and EPROM, an EEPROM or a FLASH memory) and so executed by a processor or a programmable hardware, whether or not such processor or a programmable hardware is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. A computer-implemented method (100) for comparing a simulation of a physical object with measurement data of the physical object obtained in an experiment, wherein a finite element representation of a virtual object for interacting with a finite element representation of the physical object in order to restrain an evolution of the finite element representation of the physical object in the simulation is provided for a time step tk of the simulation, the method comprising for one or more subsequent time steps tₖ₊ᵢ of the simulation:
determining (102), based on the measurement data of the physical object for the time step tₖ₊ᵢ, (k+i)-th modification data for nodes of the finite element representation of the virtual object in the time step tₖ₊ᵢ₋₁, wherein the (k+i)-th modification data indicate modifications to data assigned to the nodes of the finite element representation of the virtual object from the time step tₖ₊ᵢ₋₁ to the time step tₖ₊ᵢ;
determining (104) the finite element representation of the physical object for the time step tₖ₊ᵢ based on the finite element representation of the physical object for the time step tₖ₊ᵢ₋₁, the finite element representation of the virtual object for the time step tk+i-i and the (k+i)-th modification data; and
outputting (106) information about the interaction of the finite element representation of the virtual object with the finite element representation of the physical object.

2. The computer-implemented method (100) of claim 1, wherein determining (102) the (k+i)-th modification data comprises:
determining an estimate for the finite element representation of the physical object for the time step tₖ₊ᵢ;
allocating the measurement data of the physical object for the time step tₖ₊ᵢ to nodes of the estimate;
determining deviations between the measurement data of the physical object for the time step tₖ₊ᵢ and data assigned to the allocated nodes of the estimate;
determining distances between the nodes of the estimate;
determining virtual measurement data for the physical object for the time step tₖ₊ᵢ by interpolating the deviations using the estimate and the distances between the nodes of the estimate; and
determining the (k+i)-th modification data based on the measurement data of the physical object and the virtual measurement data for the time step tₖ₊ᵢ.

3. The computer-implemented method (100) of claim 2, wherein determining the (k+i)-th modification data based on the measurement data of the physical object and the virtual measurement data for the time step tₖ₊ᵢ comprises:
determining a finite element representation of the experiment for the time step tₖ₊ᵢ based on the measurement data of the physical object and the virtual measurement data for the time step tₖ₊ᵢ;
determining normal vectors for the nodes of the finite element representation of the experiment for the time step tₖ₊ᵢ; and
determining the (k+i)-th modification data based on the finite element representation of the experiment and the normal vectors for the nodes of the finite element representation of the experiment for the time step tₖ₊ᵢ.

4. The computer-implemented method (100) of claim 3, wherein determining the (k+i)-th modification data based on the finite element representation of the experiment and the normal vectors for the nodes of the finite element representation of the experiment for the time step tₖ₊ᵢ comprises:
determining uncertainties of the virtual measurement data based on measurement uncertainties of the measurement data of the physical object for the time step tₖ₊ᵢ;
determining an auxiliary finite element representation of the virtual object for the time step tₖ₊ᵢ based on the finite element representation of the experiment and the normal vectors for the nodes of the finite element representation of the experiment for the time step tₖ₊ᵢ using a predetermined metric for converting the uncertainties of the virtual measurement data and the measurement uncertainties of the measurement data of the physical object for the time step tₖ₊ᵢ to scalar values of the same type as the measurement data of the physical object; and
determining the (k+i)-th modification data based on a comparison of the auxiliary finite element representation of the virtual object for the time step tₖ₊ᵢ and the finite element representation of the virtual object for the time step tₖ₊ᵢ₋₁.

5. The computer-implemented method (100) of any of claims 1 to 4, wherein the virtual object is at least one surface enveloping at least part of the finite element representation of the physical object in the simulation, and wherein the finite element representation of the physical object is restricted in the simulation to not penetrate the at least one surface.

6. The computer-implemented method (100) of claim 2, wherein determining the (k+i)-th modification data based on the measurement data of the physical object and the virtual measurement data for the time step tₖ₊ᵢ comprises:
determining a finite element representation of the experiment for the time step tₖ₊ᵢ based on the measurement data of the physical object and the virtual measurement data for the time step tₖ₊ᵢ; and
determining the (k+i)-th modification data based on a comparison of the finite element representation of the experiment for the time step tₖ₊ᵢ and the finite element representation of the virtual object for the time step tₖ₊ᵢ₋₁.

7. The computer-implemented method (100) of any of claims 1, 2 or 6, wherein the virtual object is a virtual replica of the experiment for the time step tk, and wherein nodes of the finite element representation of the virtual object are coupled to corresponding nodes of the finite element representation of the physical object via coupling elements.

8. The computer-implemented method (100) of claim 7, wherein the coupling elements exhibit coupling coefficients which vary based on the difference between the respective data assigned to coupled nodes, and wherein the method further comprises:
determining uncertainties of the virtual measurement data based on measurement uncertainties of the measurement data of the physical object for the time step tₖ₊ᵢ; and
determining the coupling coefficients based on the measurement uncertainties of the measurement data and the uncertainties of the virtual measurement data underlying the data assigned to the nodes of the finite element representation of the virtual object.

9. The computer-implemented method (100) of any of claims 2 to 8, wherein determining the estimate for the finite element representation of the physical object for the time step tₖ₊ᵢ comprises:
combining the finite element representation of the physical object for the time step tₖ₊ᵢ₋₁ with (k+i)-th auxiliary modification data, wherein the (k+i)-th auxiliary modification data indicates modifications of data assigned to the nodes of the finite element representation of the physical object from the time step tₖ₊ᵢ₋₁ to the time step tₖ₊ᵢ in the simulation when the finite element representation of the virtual object is omitted.

10. The computer-implemented method (100) of claim 3, claim 4 or claim 6, wherein determining the estimate for the finite element representation of the physical object for the time step tₖ₊ᵢ comprises:
combining the finite element representation of the experiment for the time step tₖ₊ᵢ₋₁ with (k+i)-th auxiliary modification data, wherein the (k+i)-th auxiliary modification data indicate modifications of data assigned to the nodes of the finite element representation of the physical object from the time step tₖ₊ᵢ₋₁ to the time step tₖ₊ᵢ in the simulation when the finite element representation of the virtual object is omitted.

11. The computer-implemented method (100) of any of claims 1 to 10, wherein the measurement data of the physical object is position data indicating measured positions of the physical object, and wherein the data assigned to the nodes of the finite element representation of the virtual object is position data.

12. The computer-implemented method (100) of any of claims 1 to 11, wherein the measurement data of the physical object are generated by at least two different measurement systems.

13. The computer-implemented method (100) of any of claims 1 to 12, wherein outputting (106) information about the interaction comprises:
coloring one of the finite element representation of the virtual object and the finite element representation of the physical object according to a color code indicating two or more levels of interaction of the finite element representation of the virtual object with the finite element representation of the physical object; and/or
determining a scalar parameter indicating a type and/or the level of interaction of the finite element representation of the virtual object with the finite element representation of the physical object.

14. The computer-implemented method (100) of claim 13, wherein the simulation of the physical object is one of a plurality of simulations of the physical object, and wherein the method further comprises:
comparing the information about the interaction of the finite element representation of the virtual object with the finite element representation of the physical object determined for the simulation with information about the interaction of the finite element representation of the virtual object with the finite element representation of the physical object determined for other simulations of the plurality of simulations in order to obtain a comparison result; and
determining the simulation among the plurality of simulations that matches the measurement data of the physical object best based on the comparison result.

15. An apparatus (600) for comparing a simulation of a physical object with measurement data of the physical object from an experiment, wherein a finite element representation of a virtual object for interacting with a finite element representation of the physical object in the simulation in order to restrain an evolution of the finite element representation of the physical object is provided for a time step tk of the simulation, the apparatus comprising:
an input interface (610) configured to receive the measurement data of the physical object; and
a processing circuit (620) configured to perform the following for one or more subsequent time steps tₖ₊ᵢ of the simulation:
determining, based on the measurement data of the physical object for the time step tₖ₊ᵢ, (k+i)-th modification data for nodes of the finite element representation of the virtual object in the time step tₖ₊ᵢ₋₁, wherein the (k+i)-th modification data indicates modifications to data assigned to the nodes of the finite element representation of the virtual object from the time step tₖ₊ᵢ₋₁ to the time step tₖ₊ᵢ;
determining the finite element representation of the physical object for the time step tₖ₊ᵢ based on the finite element representation of the physical object for the time step tₖ₊ᵢ₋₁, the finite element representation of the virtual object for the time step tₖ₊ᵢ₋₁ and the (k+i)-th modification data; and
outputting information about the interaction of the finite element representation of the virtual object with the finite element representation of the physical object.
